# FASCICULE DE BREVET EUROPEEN

(11) **EP 1 869 712 B1**
(45) Date de publication et mention de la délivrance du brevet: **18.07.2012**
(21) Numéro de dépôt: 06726328.5
(22) Date de dépôt: 10.04.2006
(51) Int. Cl.: H01L 29/786, H01L 29/775, H01L 21/335

(54) **STRUCTURE ET PROCEDE DE REALISATION D'UN DISPOSITIF MICROELECTRONIQUE DOTE D'UN OU PLUSIEURS FILS QUANTIQUES APTES A FORMER UN CANAL OU PLUSIEURS CANAUX DE TRANSISTORS**
STRUKTUR UND VERFAHREN ZUR REALISIERUNG EINER MIT EINER ANZAHL VON QUANTENLEITUNGEN AUSGESTATTETEN MIKROELEKTRONISCHEN EINRICHTUNG MIT DER FÄHIGKEIT ZUR BILDUNG EINES ODER MEHRERER TRANSISTORKANÄLE
STRUCTURE AND METHOD FOR REALIZING A MICROELECTRONIC DEVICE PROVIDED WITH A NUMBER OF QUANTUM WIRES CAPABLE OF FORMING ONE OR MORE TRANSISTOR CHANNELS

(30) Priorité: 13.04.2005 FR 0550947
(43) Date de publication de la demande: 26.12.2007
(73) Titulaire: Commissariat à l'Énergie Atomique et aux Énergies Alternatives, 75015 Paris (FR)
(72) Inventeur: ERNST, Thomas, F-38210 Morette (FR); BOREL, Stéphan, F-38400 Saint Martin D'heres (FR)
(74) Mandataire: Poulin, Gérard
(86) Numéro de dépôt international: PCT/FR2006/050322
(87) Numéro de publication internationale: WO 2006/108987

(56) Documents cités:
- US-A- 5 965 914
- US-A- 6 127 702
- US-A1- 2004 051 150
- US-A1- 2004 166 642
- US-A1- 2004 227 187
- WU Y-C ET AL: "HIGH-PERFORMANCE POLYCRYSTALLINE SILICON THIN-FILM TRANSISTOR WITH MULTIPLE NANOWIRE CHANNELS AND LIGHTLY DOPED DRAIN STRUCTURE" APPLIED PHYSICS LETTERS, AIP, AMERICAN INSTITUTE OF PHYSICS, MELVILLE, NY, US, vol. 84, no. 19, 10 mai 2004 (2004-05-10), pages 3822-3824, XP001220931 ISSN: 0003-6951
- LIU J L ET AL: "A METHOD FOR FABRICATING SILICON QUANTUM WIRES BASED ON SIGE/SI HETEROSTRUCTURE" APPLIED PHYSICS LETTERS, AIP, AMERICAN INSTITUTE OF PHYSICS, MELVILLE, NY, US, vol. 68, no. 3, 15 janvier 1996 (1996-01-15), pages 352-354, XP000552744 ISSN: 0003-6951
- OKADA H ET AL: "A NOVEL WIRE TRANSISTOR STRUCTURE WITH IN-PLANE GATE USING DIRECT SCHOTTKY CONTACTS TO 2DEG" EXTENDED ABSTRACTS OF THE INTERNATIONAL CONFERENCE ON SOLID STATE DEVICES AND MATERIALS, JAPAN SOCIETY OF APPLIED PHYSICS. TOKYO, JA, 23 août 1994 (1994-08-23), pages 971-972, XP000543982

## Description

### DOMAINE TECHNIQUE

La présente invention se rapporte au domaine des circuits intégrés, et plus particulièrement à celui des transistors, et a pour but de présenter un dispositif microélectronique doté en particulier d'un ou plusieurs fils quantiques, optimisé(s) en terme d'agencement, ainsi que de forme ou/et de composition, et susceptible(s) de former un canal, ou un canal à plusieurs branches, ou plusieurs canaux de transistor(s), amélioré(s) en termes de performances électriques et d'encombrement.

### ART ANTÉRIEUR

Une structure classique de transistor est généralement formée, sur un substrat, par exemple de type SOI (SOI pour « silicon on insulator » ou « silicium sur isolant »), d'une région de source et d'une région de drain, par exemple sous forme respectivement d'une première zone et d'une seconde zone semi-conductrices, reliées entre elles par une troisième zone semi-conductrice ou canal, qui peut avoir une forme d'un barreau ou d'un bloc parallélépipédique. Ce barreau est recouvert d'une grille permettant de contrôler l'intensité d'un courant transitant entre la région de source et la région de drain.

On cherche continuellement à augmenter les performances des transistors en essayant d'améliorer deux facteurs normalement incompatibles: leur vitesse de fonctionnement et leur consommation.

Pour augmenter la vitesse de fonctionnement, on essaie notamment de réduire la taille des transistors, ce qui permet par ailleurs de réduire les coûts de fabrication et de réaliser des circuits intégrés avec un nombre de transistors ou une densité d'intégration de transistor plus élevée.

Diminuer la taille des transistors implique par exemple le rapprochement de la source et du drain et la réalisation d'un canal de longueur et de largeur de plus en plus faibles. Cette tendance peut entraîner des effets néfastes au bon fonctionnement des transistors tels que des « effets de canal court » (en anglais « short channel effect »). Ainsi, à mesure que l'on diminue la longueur du canal des transistors, le drain et la source ont une influence de plus en plus importante sur la conduction du canal, normalement contrôlée par la grille. Les « effets de canal court » entraînent, entre autres, une diminution de la tension seuil avec la longueur de canal et la tension de drain, ce qui entraîne une augmentation de la fuite du transistor à l'état bloqué. Ceci n'est guère compatible avec l'amélioration des performances des circuits intégrés.

Le document US 6 127 702 propose une structure de transistor comportant un canal formé de plusieurs barreaux parallélépipédiques parallèles, juxtaposés sur un substrat, et séparés entre eux par une distance établie par lithographie. Cette structure permet notamment de diminuer les effets de canal court, mais pose néanmoins des problèmes, notamment en terme de densité d'intégration, cette dernière étant limitée par le procédé de lithographie.

Le document US 5 965 914 propose quant à lui, une autre structure de transistor, dotée d'un canal formé cette fois, de barreaux parallélépipédiques superposés. Une telle structure est complexe à mettre en oeuvre, mais permet également d'améliorer les effets de canal court, et apporte des améliorations en terme de densité d'intégration, dans la mesure où son encombrement sur un substrat est moindre par rapport à celui des structures de transistors décrites précédemment.

Il se pose le problème de trouver une nouvelle structure de transistor, pour laquelle, les problèmes d'encombrement sur un substrat sont d'avantage réduits, tandis que le contrôle du canal est amélioré.

### EXPOSÉ DE L'INVENTION

La présente invention a pour but de présenter un dispositif microélectronique à effet de champ comportant un ou plusieurs fils, dits fils « quantiques », optimisé(s) en terme d'agencement, ainsi que de forme ou/et de composition, et susceptible(s) de former un canal, ou un canal à plusieurs branches, ou plusieurs canaux de transistor(s) amélioré(s). Ces fils, formant un ou plusieurs canaux de transistors, ont un agencement, ainsi qu'une forme ou/et une composition apportant aux transistors à effet de champ des améliorations, notamment en termes de densité d'intégration et de performances électriques.

L'invention prévoit également un procédé de réalisation d'un dispositif microélectronique doté d'un ou plusieurs barreaux ou tiges ou fils, dits « fils quantiques aptes à former un canal de transistor ou un canal de transistor à plusieurs branches ou plusieurs canaux de transistors, le procédé comprenant les étapes de :
a) formation dans une ou plusieurs couches minces, d'au moins un premier bloc et d'au moins un second bloc dans lesquels, respectivement, au moins une région de drain de transistor et au moins une région de source de transistor sont destinés à être formés, et d'au moins un troisième bloc ou d'une structure reliant le premier bloc et le second bloc,
b) formation en surface, et en particulier sur au moins un flanc ou sur au moins une face latérale de la structure, d'un ou plusieurs fils, reliant une première zone ou une première face du premier bloc et une autre zone ou une autre face du second bloc, aptes à former un canal ou un canal à plusieurs branches ou plusieurs canaux de transistors.

Ladite première zone du premier bloc peut être située en regard de ladite autre zone du second bloc.

Le premier bloc, le second bloc, et le troisième bloc peuvent être formés dans un empilement de couches minces.

Le procédé peut également comprendre en outre, après l'étape b) : la suppression d'au moins une partie de la structure reliant le premier bloc et le deuxième bloc, cette suppression étant sélective, vis-à-vis des fils.

Ainsi, le troisième bloc peut être prévu pour servir de structure de soutien à la formation des fils quantiques. Le troisième bloc peut éventuellement avoir une forme classique de canal de transistor et peut être supprimé ou partiellement supprimé et laisser place aux fils quantiques, optimisés en terme d'agencement ainsi que de forme ou/et de composition, et susceptibles de former une structure de canal ou une structure de canal à plusieurs branches amélioré.

Les fils formés à l'étape b) peuvent avoir une forme optimisée en particulier cylindrique ou sensiblement cylindrique.

Selon une possibilité, les fils formés à l'étape b) peuvent être dotés d'un profil arrondi ou présentant une courbure. Selon plusieurs possibilités, les fils peuvent être dotés d'une section circulaire ou d'une section sensiblement circulaire ou d'une section ovale ou d'une section sensiblement ovale.

Les fils quantiques peuvent être éventuellement dotés d'une section comportant au moins un renfoncement ou/et au moins un méplat.

Selon une autre possibilité de mise en oeuvre du procédé, la première zone du premier bloc et ladite autre zone du second bloc peuvent être à base d'un ou de matériaux différent(s) du matériau à base duquel les fils sont formés à l'étape b).

Selon une variante de mise en oeuvre du procédé, qui peut être éventuellement combinée avec les précédentes, des fils distincts ou disjoints peuvent être formés à l'étape b).

Selon une autre variante de mise en oeuvre du procédé, qui peut être éventuellement combinée avec les précédentes, un ou plusieurs fils distincts ou disjoints du support peuvent être réalisés à l'étape b).

L'étape a) de réalisation du premier, deuxième et troisième bloc peut comprendre les étapes de :
- formation d'au moins un masquage sur ledit empilement,
- gravure anisotrope de l'empilement à travers le masquage. Ce masquage est susceptible de reproduire au moins un motif de source de transistor, au moins un motif de drain de transistor, ainsi qu'au moins un motif reliant le motif de source et le motif de drain.

A l'étape b), les fils peuvent être réalisés par croissance ou croissance sélective d'au moins un matériau semi-conducteur autour ou de part et d'autre d'une ou plusieurs couches données ou ciblées de l'empilement. Cela peut permettre notamment de former plusieurs fils quantiques superposés et/ou distincts et/ou distincts du support et éventuellement au moins deux fils quantiques alignés dans une direction parallèle au plan principal du support et distincts de ce dernier.

L'empilement peut être formé d'au moins deux couches successives à base de matériaux différents ou d'au moins une paire de couches successives à base de matériaux différents.

L'empilement peut être formé d'une alternance de couches à base d'un premier matériau semi-conducteur, et d'autres couches à base d'un deuxième matériau, différent du premier matériau.

Selon une possibilité de mise en oeuvre pour laquelle l'empilement est formé d'une ou plusieurs couches à base d'un premier matériau, et d'une ou plusieurs autres couches à base d'un deuxième matériau, le procédé peut comprendre en outre après l'étape b) et avant l'étape c), les étapes de :
- gravure partielle et sélective vis-à-vis du deuxième matériau, des couches à base du premier matériau,
- formation d'une épaisseur isolante autour des couches à base du premier matériau. Cela peut permettre de protéger par un matériau isolant certaines couches de l'empilement en vue d'une croissance sélective des fils quantiques sur d'autres couches de cet empilement.

Selon un mode de réalisation particulier du procédé, l'étape b) peut être réalisée, par croissance ou par croissance par épitaxie, sur certaines couches de l'empilement, par exemple les couches à base du deuxième matériau semi-conducteur, d'un troisième matériau semi-conducteur, le troisième matériau étant différent du premier matériau et/ou du deuxième matériau.

Le procédé de réalisation peut comprendre en outre, après l'étape c), les étapes de :
- dépôt d'une couche isolante sur la structure,
- formation d'au moins une ouverture dans la couche isolante entre le premier bloc et le deuxième bloc, dévoilant la structure et les fils ou dévoilant une partie de la structure et des fils,
- gravure de la structure à travers l'ouverture, sélective vis-à-vis des fils.

Cela peut permettre notamment, d'effectuer le retrait au moins partiel de la structure, tout en préservant le premier bloc et le second bloc. Cela peut également permettre, en particulier dans un cas où l'ouverture à une forme correspondant à celle d'une grille de transistor, de préparer la formation de cette grille.

Ainsi, le procédé peut comprendre en outre : après la gravure de la structure à travers l'ouverture, la formation d'une grille de transistor dans l'ouverture.

Le procédé peut être éventuellement réalisé sur un substrat de type semi-conducteur sur isolant. Dans ce cas, le support peut être formé par exemple d'au moins une couche servant de support mécanique, par exemple semi-conductrice ou à base de quartz, et d'au moins une couche isolante reposant sur la couche semi-conductrice et sur laquelle, l'empilement de couches minces formé à l'étape a), est réalisé.

Pour cela, selon un premier aspect, l'invention met en oeuvre un dispositif microélectronique comprenant :
- un support,
- au moins un premier bloc et au moins un second bloc reposant sur le support, dans lesquels respectivement, au moins une région de drain de transistor et au moins une région de source de transistor sont aptes à être formées ou sont formées,
- un ou plusieurs barreaux ou fils de forme cylindrique ou sensiblement cylindrique, aptes à former ou formant un canal de transistor ou un canal de transistor à plusieurs branches ou plusieurs canaux de transistors, reliant une première zone du premier bloc et une autre zone du second bloc.

La première zone du premier bloc et ladite autre zone du second bloc peuvent être situées en regard l'une de l'autre.

Les fils peuvent être dotés d'un profil arrondi ou présentant une courbure. Selon plusieurs possibilités, les fils peuvent être dotés d'une section circulaire ou d'une section sensiblement circulaire ou d'une section ovale ou d'une section sensiblement ovale.

Selon une possibilité de mise en oeuvre des fils quantiques, ces derniers peuvent être dotés d'un profil comportant au moins un renfoncement ou/et au moins un méplat.

Ainsi, le dispositif microélectronique suivant l'invention comporte des fils quantiques ayant un agencement ainsi qu'une forme optimisés, en particulier cylindrique, qui permet un contrôle amélioré de conduction d'un canal ou d'un canal à plusieurs branches, ou des canaux que ces fils sont susceptibles de réaliser.

Le premier bloc et le second bloc peuvent comprendre respectivement, une ou plusieurs couches minces, dont une ou plusieurs couches semi-conductrices, par exemple un empilement de couches semi-conductrices.

Selon une possibilité de mise en oeuvre d'un tel dispositif, les fils peuvent être rattachés à une portion de la première zone du premier bloc et à une autre portion de ladite autre zone du second bloc, à base d'un matériau ou de matériaux différent(s) de celui à base duquel ou desquels ces fils sont formés. Le dispositif microélectronique suivant l'invention peut ainsi comporter des fils quantiques à base d'un matériau donné, ayant de bonnes qualités en terme de mobilité des porteurs de charge, et reliant une région de drain et une région de source à base d'un matériau ou de matériaux différent(s) dudit matériau donné.

Selon une variante de mise en oeuvre, un des fils quantiques ou plusieurs des fils quantiques voire tous les fils quantiques du dispositif peuvent être distinct(s) ou disjoint(s) ou ne pas être en contact avec le support. Un tel agencement, peut permettre d'améliorer le contrôle de la conduction des fils quantiques par une grille venant enrober ces derniers.

Selon une deuxième possibilité d'agencement, qui peut être combinée avec la précédente, le dispositif peut comporter au moins deux fils quantiques alignés dans une direction réalisant un angle non nul avec un plan principal du support. Un tel agencement peut permettre de limiter l'encombrement d'un dispositif à plusieurs fils quantiques et d'améliorer la densité d'intégration des transistors.

Selon une troisième possibilité d'agencement, qui peut être combinée avec les deux précédentes, le dispositif peut comporter au moins deux fils alignés dans une direction parallèle au plan principal du support.

Le premier bloc et le second bloc peuvent comprendre chacun au moins deux couches semi-conductrices à base de matériaux différents, dont au moins une couche à base d'un premier matériau semi-conducteur, et au moins une couche à base d'un deuxième matériau semi-conducteur, susceptible, éventuellement, d'être gravé de manière sélective vis-à-vis du premier matériau.

Selon un mode de réalisation particulier du dispositif, le premier bloc et le second bloc peuvent comprendre une alternance de couches à base d'un premier matériau semi-conducteur et de couches à base d'un deuxième matériau semi-conducteur, différent du premier matériau semi-conducteur.

Les fils quantiques peuvent être à base d'un matériau semi-conducteur et éventuellement à base d'un troisième matériau semi-conducteur, différent du premier matériau semi-conducteur et du deuxième matériau semi-conducteur. Ce troisième matériau peut être un matériau particulièrement favorable à la mobilité des porteurs de charges tel que par exemple du germanium, ou/et un matériau susceptible d'être gravé de manière sélective vis-à-vis du premier et du deuxième matériau semi-conducteur.

Le dispositif suivant l'invention peut également comprendre une grille enrobant au moins partiellement lesdits fils. Alors, selon une variante de mise en oeuvre du dispositif, le support et les fils peuvent être séparés par une portion de grille.

Les fils quantiques du dispositif peuvent éventuellement avoir une forme sensiblement cylindrique et comporter un méplat, qui peut éventuellement renseigner sur la manière dont ces fils ont été formés. Ce méplat peut être tel qu'il réalise un angle non nul ou orthogonal avec un plan principal du support.

Selon une possibilité de mise en oeuvre du dispositif microélectronique selon l'invention, ce dernier peut être réalisé à partir d'un substrat de type semi-conducteur sur isolant. Dans ce cas, le support sur lequel reposent le premier bloc et le second bloc est susceptible de comporter au moins une couche isolante en contact avec le premier et le deuxième bloc, ainsi qu'au moins une couche semi-conductrice sur laquelle repose la couche isolante.

Selon un deuxième aspect, l'invention met également en oeuvre un dispositif microélectronique comprenant :
- un support,
- au moins un premier bloc et au moins un second bloc d'une ou plusieurs couches minces reposant sur le support, dans lesquels respectivement, au moins une région de drain et au moins une région de source de transistor sont destinés à être formées,

- un ou plusieurs barreaux ou fils dits « fils quantiques » à base d'au moins un matériau donné, aptes à former un canal de transistor ou plusieurs canaux de transistors, et reliant une première zone du premier bloc et une autre zone du second bloc située en regard de ladite première zone, ladite première zone du premier bloc et/ou ladite autre zone du second bloc étant à base d'un matériau différent dudit matériau donné.

Selon une mise en oeuvre particulière de ce dispositif, les fils peuvent avoir une forme cylindrique ou sensiblement cylindrique.

Selon une possibilité, les fils peuvent être dotés d'un profil arrondi ou d'un profil comportant une courbure.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A et 1B, représentent un exemple de dispositif microélectronique selon l'invention comportant des fils quantiques aptes à former au moins un canal de transistor,
- les figures 2A et 2B, représentent un dispositif microélectronique selon l'invention comportant un ou plusieurs fils quantiques enrobés d'une grille, et formant au moins un canal de transistor,

- les figures 3A à 3I, illustrent, selon une vue en coupe, les étapes d'un procédé de réalisation d'un dispositif microélectronique selon l'invention,
- les figures 4A à 4E, illustrent, les étapes de ce même procédé, selon une vue de dessus,
- la figure 5, représente un motif de transistor,
- les figures 6A à 6H illustrent différents exemples de formes de sections ou de coupes transversales, que les fils quantiques d'un dispositif microélectronique suivant l'invention sont susceptibles d'adopter,
- les figures 7A à 7F illustrent différentes variantes de formes de sections de fils quantiques obtenues par un procédé de réalisation d'un dispositif microélectronique selon l'invention.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

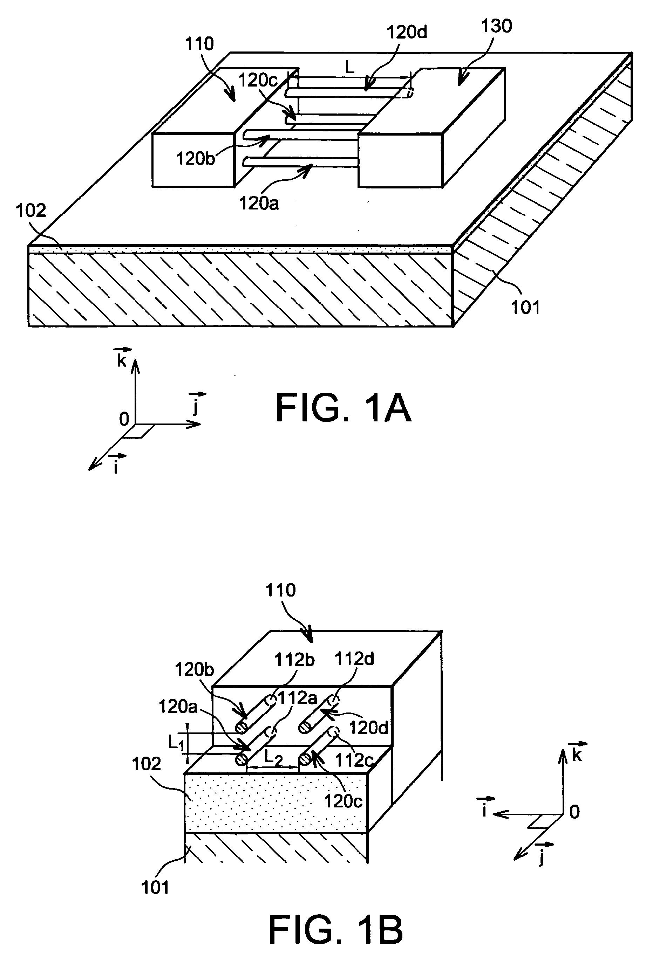

Un exemple de dispositif microélectronique suivant l'invention va à présent être décrit en liaison avec les figures 1A et 1B.

Ce dispositif comprend tout d'abord un substrat, qui peut être de type semi-conducteur sur isolant, par exemple de type SOI (SOI pour « Silicon On Insulator » ou « silicium sur isolant ») ou de type SiGeOI (SiGeOI pour « SiGe On Insulator » ou « SiGe sur isolant »), et doté notamment d'une première couche 101 de support mécanique, qui peut être à base de quartz ou à base d'un matériau semi-conducteur, par exemple à base de silicium, ainsi que d'une couche isolante 102 ou d'oxyde enterré (« burried oxide » selon la terminologie anglo-saxonne) par exemple à base de SiO₂, reposant sur la première couche 101.

La couche isolante 102 sert de support à un premier bloc 110 et à un second bloc 130, formés chacun d'au moins une couche mince ou de plusieurs couches minces empilées sur la couche isolante 102. Le premier bloc 110 et le second bloc 130 comprennent chacun une couche semi-conductrice ou plusieurs couches semi-conductrices superposées, dont au moins une couche semi-conductrice (non référencée) en contact avec la couche isolante 102.

Les blocs 110 et 130 sont destinés à former respectivement, une région de drain de transistor ou éventuellement plusieurs régions superposées de drains, et une région de source de transistor ou éventuellement plusieurs régions superposées de sources. Ainsi, les blocs 110 et 130 peuvent éventuellement comprendre chacun plusieurs couches semi-conductrices superposées ou empilées à base de matériaux semi-conducteurs différents.

Selon une possibilité de mise en oeuvre du dispositif, les blocs 110 et 130, peuvent comprendre chacun une alternance de couches semi-conductrices à base d'un premier matériau semi-conducteur, par exemple du SiGe et de couches semi-conductrices à base d'un deuxième matériau semi-conducteur, par exemple du Si.

Les blocs 110 et 130 peuvent avoir des bases respectives en contact avec la couche isolante 102 avantageusement distinctes ou disjointes entre elles. Les blocs 110 et 130 sont également reliés l'un à l'autre par l'intermédiaire d'un ou plusieurs barreaux ou tiges ou fils, par exemple, comme le montre la figure 1A (représentant une vue en perspective du dispositif), de quatre barreaux ou fils 120a, 120b, 120c, 120d.

Les fils ou barreaux 120a, 120b, 120c, 120d, sont susceptibles d'assurer une conduction électrique et sont destinés à former une structure de canal de transistor à plusieurs branches. Dans un cas notamment où, les blocs 110 et 130 forment respectivement, plusieurs régions de drains de transistors empilés et plusieurs régions de sources de transistors empilés, les fils 120a, 120b, 120c, 120d, peuvent être destinés à former plusieurs canaux de transistors différents.

Ces barreaux ou fils 120a, 120b, 120c, 120d, que l'on appellera également « fils quantiques » relient dans le sens de leur longueur L (la longueur L étant définie sur la figure 1A dans une direction parallèle au vecteur *j̅* d'un repère orthogonal [o; *i̅*; *̅j̅*̅;̅ *k̅*]), une première face ou une première zone appartenant au premier bloc 110, et une autre première face ou une autre première zone appartenant au second bloc 130, située en regard de ladite première face du premier bloc 110. La longueur L des barreaux ou fils 120a, 120b, 120c, 120d, qui correspond également à une distance séparant les blocs 110 et 130, peut être comprise entre 10 nanomètres et 1000 nanomètres, ou être par exemple de l'ordre de 50 nanomètres.

L'agencement des fils quantiques est optimisé, et peut permettre de conférer des propriétés électriques améliorées au canal de transistor ou aux canaux de transistors que ces derniers réalisent ou sont susceptibles de réaliser. Un ou plusieurs fils quantiques du dispositif microélectronique peuvent avoir été formés de manière à ne pas être en contact avec le support sur lequel repose les blocs 110 et 130. Dans l'exemple illustré par les figures 1A et 1B, les fils ou barreaux 120a, 120b, 120c, 120d, sont formés au dessus des faces inférieures respectives des blocs 110 et 130, et ne sont pas en contact avec la couche isolante 102. Un ou plusieurs fils quantiques du dispositif microélectronique peuvent également avoir été formés de manière à ne pas être en contact avec la face supérieure ou le dessus des blocs 110 et 130 dans lesquels sont réalisées les régions de source et de drain. Dans l'exemple illustré par les figures 1A et 1B, les fils ou barreaux 120a, 120b, 120c, 120d, sont formés au dessous des faces supérieures respectives des blocs 110 et 130, et ne sont pas en contact avec la couche isolante 102.

L'agencement des fils quantiques peut être également optimisé, en ce qui concerne l'espace ou la place que ces derniers occupent sur le substrat. Comme le montre la figure 1B (représentant une vue en coupe entre les premier bloc 110 et le second bloc 130 du dispositif), un premier fil 120a et un deuxième fil 120b, sont alignés dans une direction réalisant un angle non-nul, par exemple de 90°, avec le plan principal de la couche semi-conductrice 101 ou de la couche isolante 102. Dans une direction sensiblement parallèle au plan principal de la couche isolante 102, un troisième fil semi-conducteur 120c, et un quatrième fil semi-conducteur 120d, sont alignés respectivement, avec le premier fil 120a et avec le deuxième fil 120b.

Le premier fil 120a, et le deuxième fil 120b, peuvent être espacés entre eux d'une distance L₁, comprise par exemple entre 0 et 100 nanomètres, ou par exemple de l'ordre de 20 nanomètres et sont de préférence distincts ou disjoints.

Le premier fil 120a, et le deuxième fil 120b, peuvent être respectivement espacés du troisième fil 120c, et du quatrième fil semi-conducteur 120d, d'une distance L₂, comprise par exemple entre 10 nanomètres et 100 nanomètres, ou par exemple de l'ordre de 20 nanomètres.

Les fils quantiques du dispositif microélectronique, peuvent également avoir une forme optimisée, qui facilite le contrôle de conduction du canal à plusieurs branches ou des canaux que ces fils sont aptes à réaliser. Comme le montre les figures 1A et 1B, les fils 120a, 120b, 120c, 120d, peuvent avoir une forme de cylindre, en particulier à profil arrondi ou présentant une courbure.

Les fils 120a, 120b, 120c, 120d, cylindriques, peuvent avoir une section circulaire ou dite « sensiblement » circulaire ou, selon une autre possibilité, être dotés d'une section ovoïde ou dite « sensiblement ovoïde ». Les fils 120a, 120b, 120c, 120d, ayant été réalisés par un procédé de microélectronique, par exemple à l'aide d'une ou plusieurs étapes épitaxie(s), ces derniers n'ont pas nécessairement une forme géométrique parfaite, et en particulier une section de forme géométrique parfaite.

Selon une possibilité, les fils 120a, 120b, 120c, 120d, sont susceptibles de comporter au moins un méplat, et en particulier un méplat orienté dans une direction réalisant un angle non nul avec le plan principal de la couche isolante 102 (le plan principal de la couche isolante 102 étant un plan appartenant à la couche 102, et parallèle à un plan [o; *i̅*; *j̅*] du repère orthogonal [o; *i̅*; *j̅*; *k̅*] défini sur les figures 1A et 1B).

Les fils 120a, 120b, 120c, 120d, sont également susceptibles de comporter un renfoncement ou une encoche, et en particulier un renfoncement ou une encoche qui s'étend dans la direction d'allongement des fils (la direction d'allongement des fils étant une direction parallèle au vecteur *j̅* du repère orthogonal [o; *i̅*; *j̅*; *k̅*] défini sur les figures 1A et 1B).

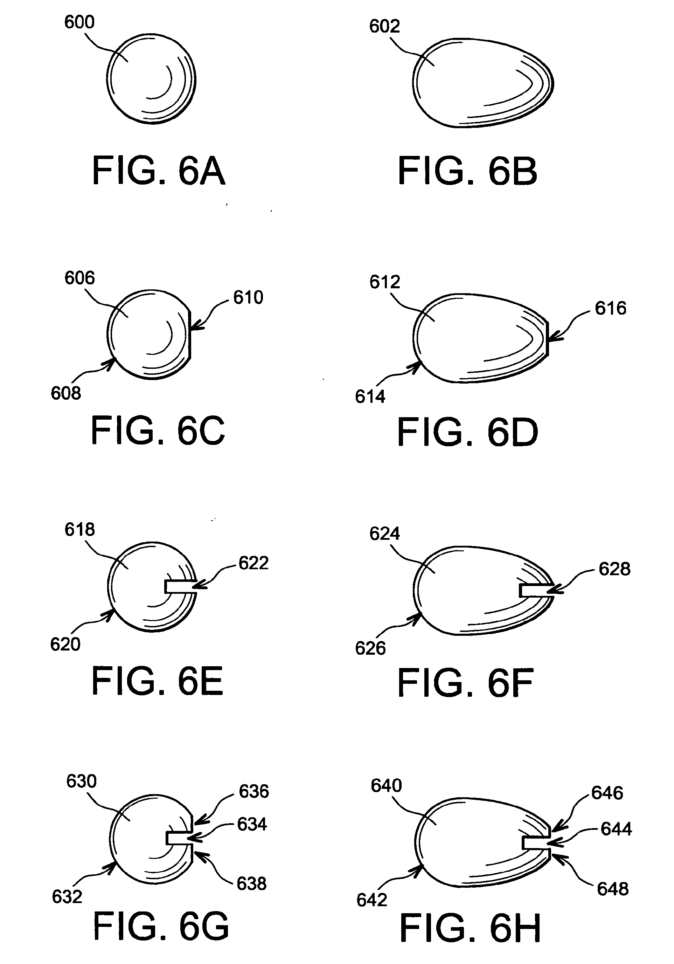

Sur les figures 6A à 6H sont illustrés différents exemples de formes de sections ou de coupes transversales, que les fils 120a, 120b, 120c, 120d, sont susceptibles d'adopter :
- un premier exemple de fil à section circulaire 600, est illustré sur la figure 6A,
- un deuxième exemple de fil, doté d'une section ovoïde 602, est illustré sur la figure 6B,
- un troisième exemple de fil, doté d'une section 606 dite « sensiblement circulaire » est illustré sur la figure 6C. Ce troisième exemple de fil comporte une section 606, dont une plus grande portion du contour ou une plus grande partie du contour, notée 608, a une forme d'arc de cercle, tandis qu'une portion inférieure du contour ou une plus petite partie du contour, notée 610, est rectiligne et forme un méplat pour le fil,
- un quatrième exemple de fil, doté d'une section 612 dite « sensiblement ovoïde » est illustré sur la figure 6D. Ce quatrième exemple de fil comporte une section sensiblement ovoïde 612, dont une plus grande portion du contour ou une plus grande partie notée 614 du contour, a une forme ovale, tandis qu'une portion inférieure ou une plus petite partie notée 616 du contour, est rectiligne et forme un méplat pour le fil,
- un cinquième exemple de fil, doté d'une section 618, dite « sensiblement circulaire » est illustré sur la figure 6E. Ce cinquième exemple de fil comporte une section 618, dont une plus grande portion ou plus grande partie 620 du contour, a une forme d'arc de cercle, tandis qu'une portion inférieure ou plus petite partie 622 du contour, forme un renfoncement ou une encoche dans le fil,
- un sixième exemple de fil, doté d'une section 624 dite « sensiblement ovoïde » est illustré sur la figure 6F. Ce sixième exemple de fil comporte une section 624, dont une plus grande portion du contour ou une plus grande partie 626 du contour a une forme ovale, tandis qu'une portion inférieure du contour ou plus petite partie 628 du contour forme un renfoncement ou une encoche dans le fil,
- un septième exemple de fil, doté d'une section 630 dite « sensiblement circulaire » est illustré sur la figure 6G. Ce septième exemple de fil comporte une section 630, dont une plus grande portion du contour ou une plus grande partie 632 du contour a une forme d'arc de cercle, tandis qu'une portion inférieure du contour ou plus petite partie 634 du contour forme à la fois un renfoncement ou une encoche 634 dans le fil et des méplats 636 et 638, de part et d'autre du renfoncement 634,
- un huitième exemple de fil, doté d'une section 640 dite « sensiblement ovoïde » est illustré sur la figure 6H. Ce huitième exemple de fil comporte une section 640, dont une plus grande portion du contour ou une plus grande partie 642 du contour a une forme ovale, tandis qu'une portion inférieure du contour ou plus petite partie du contour 644 forme à la fois un renfoncement ou une encoche 644 dans le fil et des méplats 646 et 648, de part et d'autre du renfoncement 644.

Dans un cas où les barreaux ou fils 120a, 120b, 120c, 120d, ont une forme de cylindre à base circulaire ou ont une section sensiblement circulaire, ces derniers peuvent avoir un diamètre d (le diamètre d étant défini sur la figure 1B dans une direction parallèle au vecteur *i̅* d'un repère orthogonal [o; *i̅*; *j̅*; *k̅*] compris par exemple entre 1 et 15 nanomètres, ou par exemple de l'ordre de 5 nanomètres.

En ce qui concerne la composition des fils quantiques, au moins un des fils ou barreaux 120a, 120b, 120c, 120d, a avoir été formé à base d'un troisième matériau semi-conducteur, qui est différent du ou des matériaux à base desquels les blocs 110 et 130 sont formés. Sur la figure 1B par exemple, au moins un des fils ou barreaux 120a, 120b, 120c, 120d, est à base d'un matériau différent de celui des portions 112a, 112b, 112c, 112d, du bloc 110 auxquelles ces fils sont respectivement rattachés. Le troisième matériau semi-conducteur peut être un matériau choisi pour ses performances électriques, notamment en terme de mobilité des porteurs de charges, tel que par exemple du germanium.

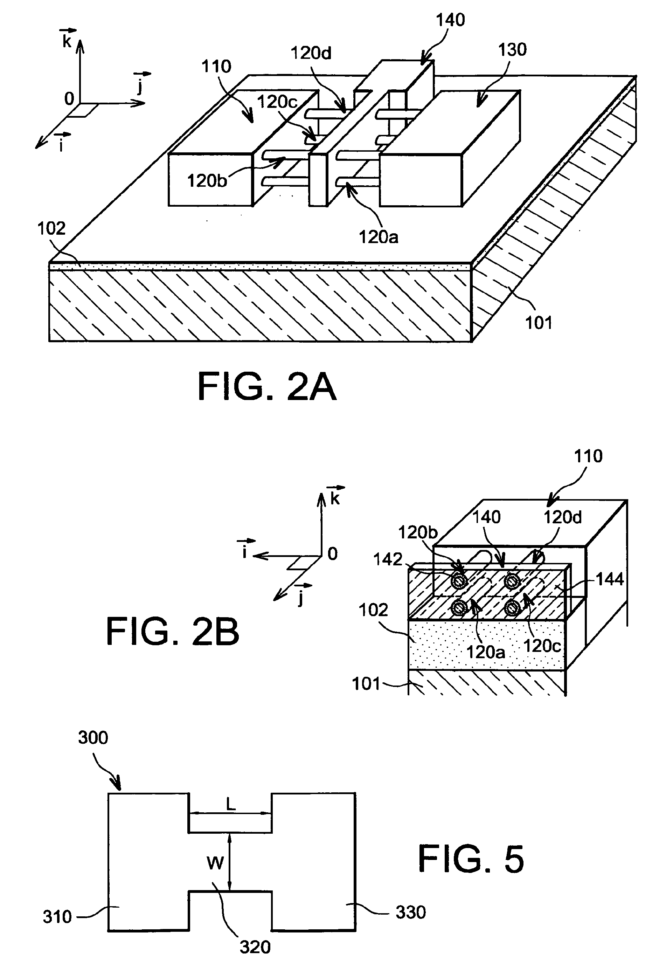

Le dispositif qui vient d'être décrit en liaison avec les figures 1A et 1B, peut être complété par une grille 140 formée entre les blocs 110 et 130, qui enrobe les fils 120a, 120b, 120c, 120d, et permet de contrôler la conduction de ces derniers. Cette grille 140 peut former une bague autour des fils quantiques 120a, 120b, 120c, 120d, sur une partie de leur longueur L, et peut être réalisée de manière à ne pas être en contact avec les blocs 110 et 130. Un matériau diélectrique 142 de grille, par exemple du SiO₂ ou un matériau diélectrique communément appelé « high-k » (ou de constante diélectrique k élevée) tel que par exemple du HfO₂, ou du Al₂O₃, ou du ZrO₂, et d'épaisseur qui peut être conforme, comprise par exemple entre 0,5 et 5 nanomètres, est formé autour des fils 120a, 120b, 120c, 120d. La partie des fils 120a, 120b, 120c, 120d, entourée par le diélectrique 142, se trouve insérée dans un matériau 144 de grille, semi-conducteur tel que par exemple du polysilicium ou conducteur, tel que par exemple du TiN ou du W. De part l'agencement des fils ou barreaux 120a, 120b, 120c, 120d, du dispositif, à l'endroit entre les blocs 110 et 130 où la grille 140 est formée, la couche isolante 102 peut être séparée de chacun des fils 120a, 120b, 120c, 120d, par le diélectrique 142 et le matériau 144 de grille, tandis que les fils peuvent être séparés entre eux par le diélectrique 142 et le matériau 144 de grille (figures 2A et 2B, ces figures représentant respectivement, le dispositif de la figure 1A et le dispositif de la figure 1B auxquels ont été ajouté une grille 140 de transistor).

Un exemple de procédé de réalisation d'un dispositif microélectronique suivant l'invention, du type de celui décrit précédemment, va à présent être donné.

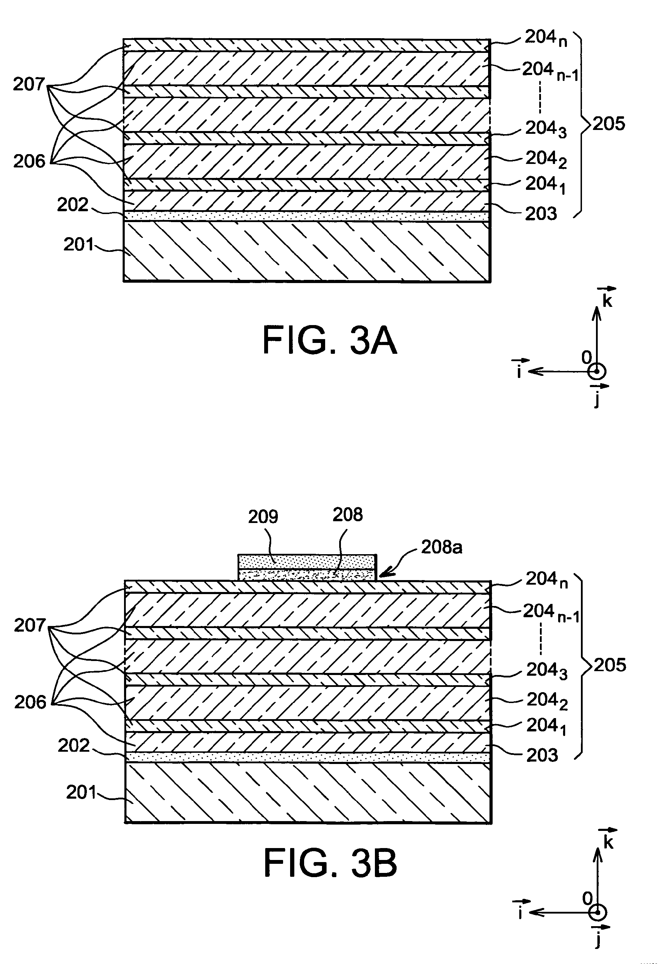

La première étape de ce procédé illustrée sur la figure 3A, consiste à réaliser un empilement de couches minces sur un substrat, qui peut être de type semi-conducteur sur isolant, et comprendre une première couche semi-conductrice 201, par exemple à base de silicium, sur laquelle repose une couche isolante 202 par exemple une couche d'oxyde enterré (« burried oxide » selon la terminologie anglo-saxonne) à base de SiO₂, elle-même recouverte d'une deuxième couche semi-conductrice 203. Cette deuxième couche semi-conductrice 203 peut être par exemple à base de silicium ou de SiGe. Plusieurs autres couches 204₁, ..., 204ₙ (avec n un entier, par exemple impair) sont réalisées sur la deuxième couche semi-conductrice 203, et forment avec cette dernière un empilement 205 de couches minces sur la couche isolante 202.

Les couches 204₁, ..., 204ₙ peuvent être des couches semi-conductrices, formées par exemple, par plusieurs épitaxies successives à partir de la deuxième couche semi-conductrice 203. Les couches 203, 204₁, ..., 204ₙ ont des épaisseurs (mesurées dans une direction orthogonale à un plan principal de la couche isolante 202, et parallèle au vecteur *k̅* du repère [0; *i̅*; *j̅*; *k̅*] défini sur la figure 3A) par exemple comprises entre 1 et 100 nanomètres ou entre 1 et 30 nanomètres.

L'empilement 205 peut être formé d'une alternance de couches notées 203, 204₂, 204₄, ..., 204ₙ à base d'un premier matériau 206, qui peut être semi-conducteur, tel que par exemple du SiGe, et de couches notées 204₁, 204₃, ..., 204ₙ₋₁ à base d'un deuxième matériau 207, différent du premier matériau 206. Le premier matériau 206 peut être un matériau susceptible de pouvoir être gravé de manière sélective vis-à-vis du deuxième matériau 207. Le deuxième matériau 207 peut être quant à lui, un matériau cristallin favorisant la croissance par épitaxie, par exemple un matériau semi-conducteur tel que du silicium, ou du GaAs, ou du INP.

Selon une possibilité de mise en oeuvre, les couches 203, 204₂, ..., 204ₙ₋₁ à base du premier matériau 206 peuvent avoir une épaisseur e₁, comprise par exemple entre 1 et 20 nanomètres, plus épaisse que celle des couches 204₁, 204₃, ..., 204ₙ à base du deuxième matériau 207, qui peuvent, quant à elles, avoir une épaisseur e₂, par exemple entre 1 et 15 nanomètres.

Une fois l'empilement 205 réalisé, on effectue le dépôt d'une couche de masque dur 208, par exemple à base de Si₃N₄ ou de SiO₂, ou à base d'un autre matériau apte à protéger l'empilement 205 d'une gravure telle que, par exemple, une gravure plasma. Ensuite, on dépose une couche de résine photosensible 209, par exemple à base de polyimide, sur la couche de masque dur 208, et l'on définit dans la couche de résine 209, par exemple par une méthode de photolithographie, un masque de résine comportant une pluralité de motifs.

Ensuite, on effectue une gravure anisotrope de la couche 208 de masque dur protégée par le masque de résine 209, afin de réaliser un masque dur sous le masque de résine, reproduisant la pluralité de motifs de ce dernier (figure 3B). Parmi la pluralité de motifs du masque de résine et du masque dur, figurent un ou plusieurs motifs du type de ceux représentés sur la figure 5, dont au moins un premier motif 310 de région de drain de transistor 300, par exemple de forme rectangulaire, au moins un deuxième motif 330 de région de source de transistor 300, qui peut être semblable au motif de région de drain, ainsi qu'au moins un troisième motif, reliant le premier motif 310 et le deuxième motif 330. Le troisième motif 320, peut avoir par exemple une forme et des dimensions correspondant à celles d'un motif classique de canal de transistor 300, tel qu'un motif rectangulaire de largeur W, par exemple compris entre 10 nanomètres et 1000 nanomètres et de longueur L, par exemple entre 5 nanomètres et 1000 nanomètres.

Après formation du masque dur 208, le masque de résine 209 peut être éventuellement retiré par un procédé de délaquage, par exemple à l'aide d'un plasma oxydant.

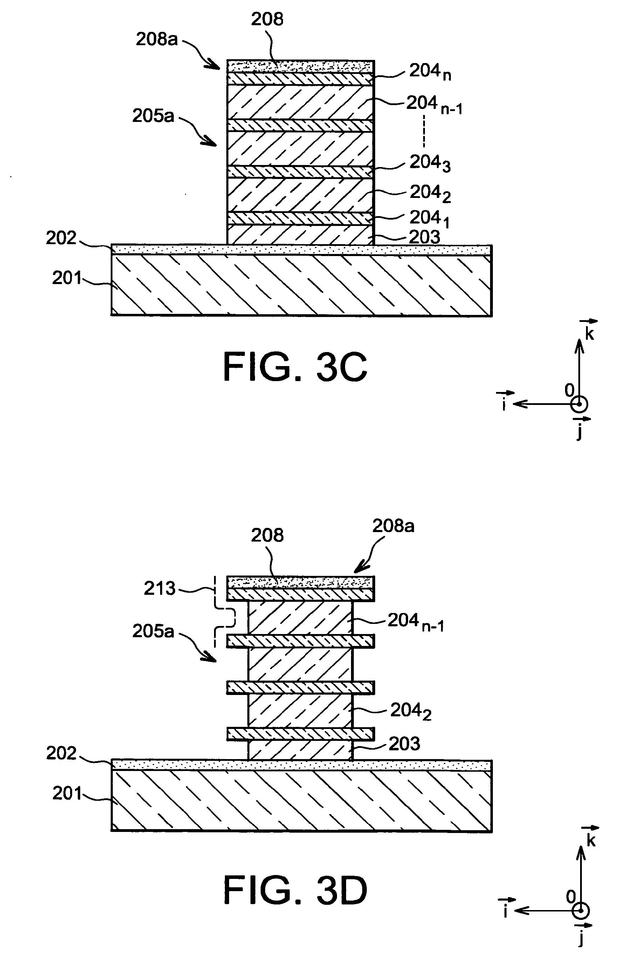

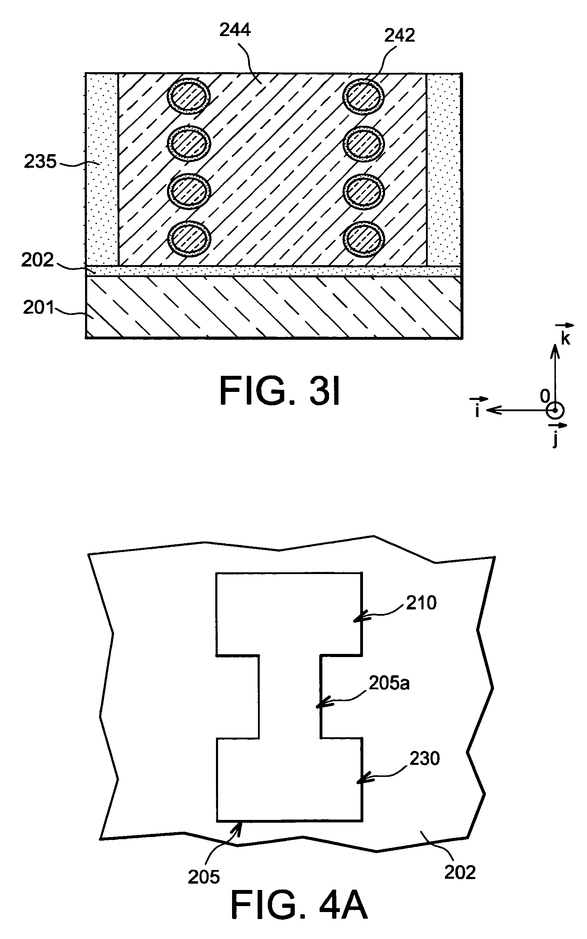

On procède ensuite à une première étape de gravure des couches 203, 204₁, ..., 204ₙ, situées sous le masque dur 208, afin de reproduire les motifs de ce dernier dans l'empilement 205. La gravure peut être de type anisotrope, et réalisée par exemple à l'aide d'un plasma à base de CF₄, HBr, O₂. La figure 4A représente une vue de dessus, sans le masque dur 208, de l'empilement 205 une fois gravé. Cet empilement 205, comporte notamment une première partie ou un premier bloc 210 reproduisant le premier motif 310 et dans lequel au moins une zone active, par exemple une région de source est destinée à être réalisée, une deuxième partie ou un second bloc 230 reproduisant le deuxième motif 330 et dans lequel au moins une zone active, par exemple une région de drain est destinée à être réalisée, ainsi qu'au moins une troisième partie 205a, reproduisant le troisième motif 320 reliant le premier bloc 210 et le deuxième bloc 230. La troisième partie 205a de l'empilement 205, constitue une structure, représentée selon une coupe transversale sur la figure 3C, formée d'un empilement, de parties des couches 203, 204₁, ..., 204ₙ, gravées, situées sous une portion notée 208a du masque dur 208, et qui reproduisent le troisième motif 320.

Ensuite, on effectue une seconde gravure de l'empilement 205, qui peut être isotrope, et sélective, de manière à retirer partiellement certaines des couches 203, 204₁, 204₂, ..., 204ₙ, de l'empilement 205, par exemple celles 203, 204₂, ..., 204ₙ₋₁ à base du premier matériau 206.

Dans le cas où les couches 203, 204₂, ..., 204ₙ₋₁ sont à base d'un premier matériau semi-conducteur, tel que par exemple du SiGe tandis que les couches 204₁, 204₃, ..., 204ₙ sont à base d'un deuxième matériau semi-conducteur tel que par exemple du silicium, la gravure peut être une gravure isotrope du premier matériau semi-conducteur, sélective vis-à-vis du deuxième matériau semi-conducteur. Une telle gravure peut être réalisée par exemple à l'aide d'un plasma à base de fluor, par exemple à base de CF₄ ou de NF₃ dans un cas où le premier matériau 206 est du SiGe. Dans un autre cas, où le premier matériau 206 est du Si, la gravure sélective peut être réalisée par exemple à l'aide d'un plasma à base de CF₄ + CH₂F₂+N₂+O₂.

L'empilement 205 étant protégé sur le dessus par le masque dur 209, la seconde gravure permet d'effectuer un retrait de portions des couches 203, 204₂, ..., 204ₙ₋₁, à base du premier matériau 206 semi-conducteur, de part et d'autre de la structure 205a, au niveau des flancs ou faces latérales de cette dernière (figure 3D, les flancs ou faces latérales de la structure 205a étant des parties de cette dernière parallèles au plan [o; *j̅*; *k̅*] sur cette figure).

De manière préférable, la seconde étape de gravure sélective impacte les couches 203, 204₂, 204₄, ..., 204ₙ₋₁ à base du premier matériau 206 et laisse les autres couches 204₁, 204₃, ..., 204ₙ à base du deuxième matériau 207 intactes.

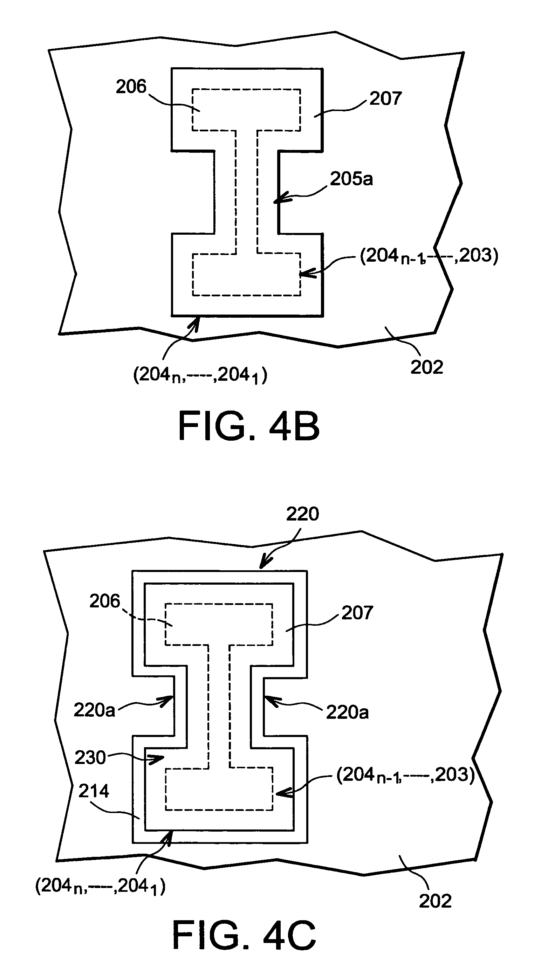

Comme le montre la figure 4B, représentant une vue de dessus de l'empilement 205, sans le masque dur 208, et après la seconde gravure, les couches gravées 203, 204₂, 204₄, ..., 204ₙ₋₁ ont des étendues inférieures à celles des autres couches 204₁, 204₃, ..., 204ₙ₋₁ à base du deuxième matériau semi-conducteur (les couches 204₂, 204₄, ..., 204ₙ₋₁, d'une part et 204₁, 204₃, ..., 204ₙ₋₁, d'autre part étant délimitées sur cette figure 4B, respectivement, par des traits discontinus, et par un trait continu).

Il résulte, à la suite de la seconde étape de gravure, que l'empilement 205 et notamment la structure 205a comporte sur ses flancs, ou sur chacune de ses faces latérales, un profil dentelé 213 (représenté par des traits discontinus sur la figure 3D). Ce profil dentelé 213 peut être un profil en créneaux. En effet, suivant la qualité de la gravure sélective précédemment décrite, les blocs de couches empilées formant la structure 205a peuvent avoir une forme proche d'une forme parfaitement parallélépipédique. Des blocs empilés de forme proche d'une forme parfaitement parallélépipédique et de largeurs différentes les unes des autres réalisent un profil en créneau.

Ensuite, on forme sur les flancs ou faces latérales de la structure 205a, des bouchons isolants ou espaceurs 212 isolants (« spacers selon la terminologie anglo-saxonne), de manière à combler au moins partiellement les parties des couches 203, 204₂, ..., 204ₙ₋₁ qui ont été retirées par gravure sélective de l'empilement 205. Avantageusement, les bouchons isolants 212 comblent totalement les parties des couches 203, 204₂, ..., 204ₙ₋₁, qui ont été retirées lors de la gravure sélective de l'empilement 205.

La formation de ces espaceurs 212 isolants peut être réalisée tout d'abord par un dépôt conforme d'une couche diélectrique 211, par exemple à base de Si₃N₄, et d'épaisseur comprise entre 20 à 50 nanomètres, sur l'empilement 205 et en particulier sur la structure 205a, puis, une gravure partielle, isotrope, de la couche diélectrique 211 déposée. Cette gravure partielle est réalisée de manière à ne conserver la couche diélectrique 211, de préférence qu'autour des parties retirées lors de la seconde étape de gravure, des couches 203, 204₂, ..., 204ₙ₋₁, à base du premier matériau 206. L'épaisseur restante de la couche diélectrique 211 forme alors des espaceurs isolants 212 de part et d'autre de la structure 205a, sur les flancs ou faces latérales de cette dernière. L'épaisseur de la couche diélectrique 211, qui est conservée, peut éventuellement être telle que, après formation des espaceurs 212, la structure 205a comporte sur ses côtés ou faces latérales, un nouveau profil, plan ou quasi plan.

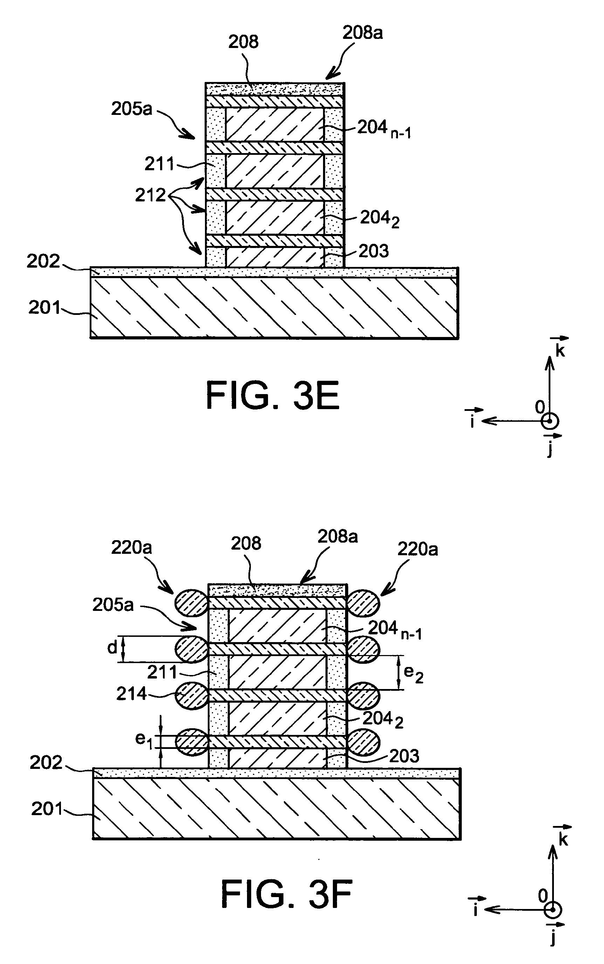

Suite à la réalisation des espaceurs 212, l'empilement 205, et en particulier la structure 205a, est recouverte et protégée sur le dessus par la partie 208a du masque dur 208, et comporte sur ses côtés ou flancs ou faces latérales, une alternance de zones ou bandes isolantes formées par les espaceurs isolants 212, et de zones ou bandes semi-conductrices formées par les couches 204₁, ..., 204ₙ à base du deuxième matériau 207 semi-conducteur (figure 3E).

Sur chacune des zones ou bandes formées par les couches 204₁, ..., 204ₙ₋₁, à base du deuxième matériau 207 semi-conducteur, affleurant sur les côtés ou flancs de l'empilement 205, on forme une épaisseur à base d'un troisième matériau 214 semi-conducteur, par exemple à l'aide d'une croissance par épitaxie. Cette épitaxie du troisième matériau 214 sur le deuxième matériau 207, est sélective vis-à-vis des espaceurs isolants 212.

Ainsi, les zones à base du deuxième matériau semi-conducteur, situées sur les flancs ou côtés, ou faces latérales de l'empilement 205, peuvent servir de germe cristallin de départ pour faire croître des épaisseurs 220 semi-conductrices par exemple entre 1 et 15 nanomètres, à base d'un troisième matériau 214 semi-conducteur. Les épaisseurs 220 peuvent avoir la forme de blocs cylindriques ou sensiblement cylindriques, qui entourent l'empilement 205. Des portions, notées 220a, de ces blocs cylindriques longent les faces latérales ou côtés ou flancs de la structure 205a. Ces portions forment des fils 220a cylindriques ou barreaux 220a cylindriques ou tiges cylindriques 220a, en particulier à profil arrondi ou courbe, qui relient la première partie ou premier bloc 210 et la deuxième partie ou deuxième bloc 230 de l'empilement 205 (figures 4C et 3F, ces figures représentant respectivement, une vue de dessus de l'empilement 205 sans le masque dur 208, et une vue en coupe de la structure 205a entre la première partie 210 et la deuxième partie 230 de l'empilement.

Les fils 220a cylindriques, peuvent par exemple avoir une section circulaire comme cela est illustré sur la figure 3F ou, selon une autre possibilité, une section ovoïde.

Les fils 220a étant réalisés par un procédé de microélectronique, par exemple à l'aide d'une croissance par épitaxie(s), ces derniers n'ont pas nécessairement une forme géométrique parfaite, et en particulier une section de forme géométrique parfaite. Ainsi à l'interface avec les couches 204₁, ..., 204ₙ₋₁, à base du deuxième matériau 207 sur lesquelles les fils 220a ont été formés, ces fils 220a sont susceptibles de comporter au moins un méplat, ou/et une encoche ou un renfoncement.

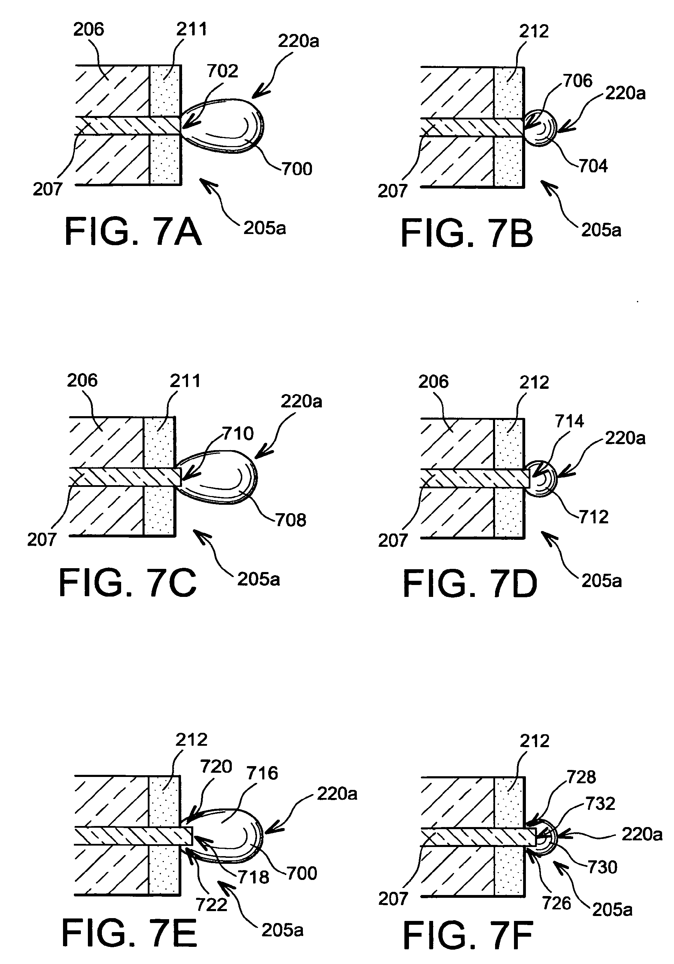

Les figures 7A à 7F illustrent différentes variantes de formes de sections, que les fils 220a sont susceptibles d'adopter. Ces formes de sections peuvent dépendre notamment, du profil des faces latérales ou flancs de la structure 205a.

Les figures 7A et 7B (représentant chacune une vue en coupe d'une partie de la structure 205a entre la première partie 210 et la deuxième partie 230 de l'empilement 205) illustrent respectivement un exemple de fil doté d'une section sensiblement ovoïde 700 et d'un méplat 702 contre la structure 205a, et un autre exemple de fil doté d'une section sensiblement circulaire 704, et d'un méplat 706 contre la structure 205a.

Les figures 7C et 7D (représentant chacune une vue en coupe d'une partie de la structure 205a entre la première partie 210 et la deuxième partie 230 de l'empilement 205), illustrent respectivement, un exemple de fil doté d'une section sensiblement ovoïde 708 et d'un renfoncement ou d'une encoche 710, et un autre exemple de fil 220a doté d'une section sensiblement circulaire 712 et d'un renfoncement ou d'une encoche 714.

Les figures 7E et 7F (représentant chacune une vue en coupe d'une partie de la structure 205a entre la première partie 210 et la deuxième partie 230 de l'empilement 205) illustrent respectivement un exemple de fil 220a doté d'une section sensiblement ovoïde 716 ainsi que d'une encoche 718 et de méplats 720 et 722 de part et d'autre de l'encoche 718, et un autre exemple de fil 220a doté d'une section sensiblement circulaire 730, ainsi que d'une encoche 732 et de méplats 734 et 736 de part et d'autre de l'encoche 732.

Le troisième matériau semi-conducteur 214, à base duquel sont réalisés les fils 220a, peut être différent du premier matériau 206 semi-conducteur et du deuxième matériau semi-conducteur 207 à base desquels les couches 203, 204₂, ..., 204ₙ d'une part et les couches 204₁, 204₃, ..., 204ₙ₋₁, d'autre part sont respectivement formées. Ce troisième matériau 214 semi-conducteur peut être un matériau choisi pour ses performances électriques, notamment en termes de mobilité des porteurs de charges, par exemple du Germanium.

Les tiges 220a ou barreaux 220a ou fils 220a, reliant des blocs 210 et 230 dans lesquels, respectivement, une région de source et une région de drain sont destinés à être formées, ces fils 220a, sont prévus pour servir de fils quantiques et former une structure de canal de transistor à plusieurs branches ou éventuellement plusieurs canaux de transistors.

Ensuite, on recouvre l'empilement 205 d'une couche isolante 235, par exemple à base à base de SiO₂, ou d'oxyde HTO (HTO pour « High Température Oxide ») ou de Si₃N₄. Cette couche isolante 235 peut être réalisée avec une épaisseur supérieure à la hauteur de l'empilement 205, de manière à recouvrir entièrement ce dernier.

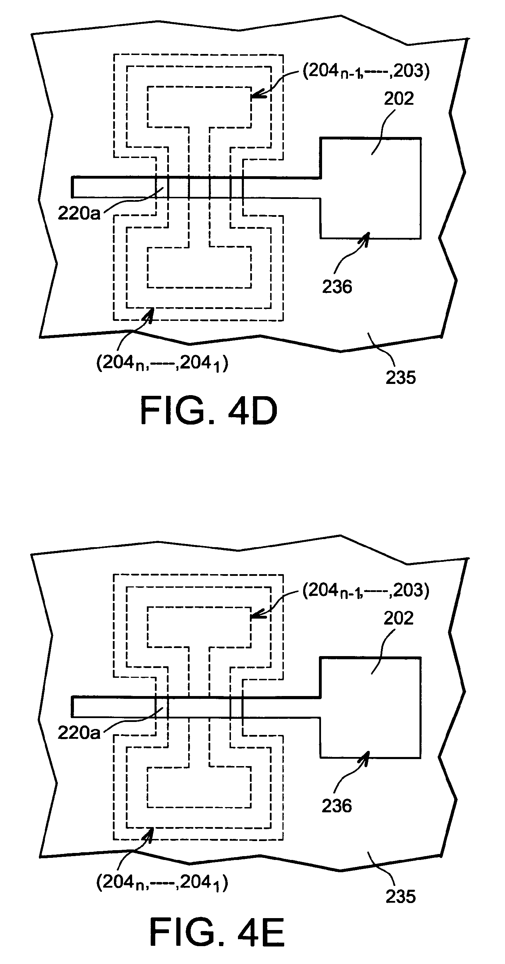

Une cavité 236, est ensuite réalisée dans la couche isolante 235. Comme le montre la figure 4D (représentant une vue de dessus de l'empilement 205, sans le masque 208), recouvert par la couche isolante 235, la cavité 236 peut avoir un dessin et un emplacement correspondant à celui d'une grille de transistor.

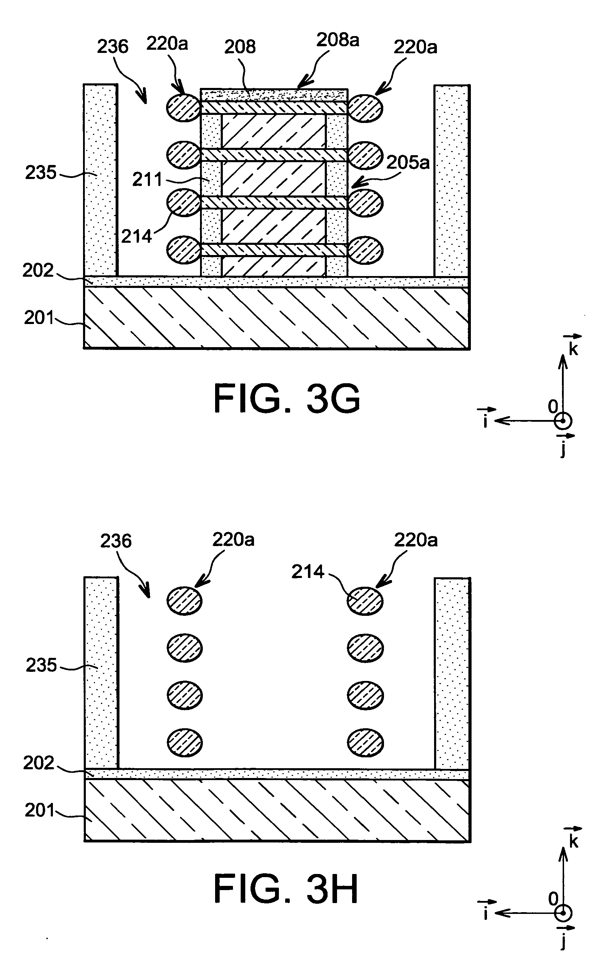

La cavité 236 peut être réalisée par exemple à l'aide d'étapes de photolithographie et de gravure, de manière à dévoiler la couche isolante 202 du substrat 201, ainsi qu'au moins une partie de la structure 205a, et une portion des fils 220a formés de part et d'autre de cette dernière (figure 4D et figure 3G).

Ensuite, on retire les parties de la structure 205a dévoilées par la cavité 236. Les portions ou parties des fils 220a qui sont dévoilées par la cavité 236, sont quant à elles conservées.

Pour effectuer ce retrait, on peut tout d'abord retirer dans la cavité 236, le matériau diélectrique 211 formant les espaceurs 212, à l'aide d'une gravure chimique, par exemple au moyen d'une solution aqueuse à base de H₃PO_{4.} Selon une autre possibilité, ce retrait peut être effectué à l'aide d'un plasma, par exemple à base de CF₄+CH₂F₂+N₂+O₂, puis réaliser une gravure, sélective vis-à-vis du troisième matériau semi-conducteur.

Cette gravure sélective vis-à-vis du troisième matériau semi-conducteur, peut être, par exemple, une gravure sèche ou une gravure chimique à l'aide par exemple de TMAH (TMAH pour tétra-méthyl ammonium hydroxyle). Seules les portions des fils ou barreaux 220a dévoilées par la cavité 236, sont alors conservées dans cette dernière (figure 4E, cette figure représentant une vue de dessus de l'empilement 205, recouvert par la couche isolante 235).

Comme le montre la figure 3H (cette figure représentant une vue en coupe de l'empilement 205 située entre la première partie 210 de cet empilement et la deuxième partie 230 de cet empilement, dans lesquelles respectivement une région de drain et une région de source sont destinées à être formées) suite au retrait dans la cavité 236 de la structure 205a, les portions des fils 220a, situées dans la cavité 236 sont détourées, et en suspension dans cette cavité 236.

Une grille 240 peut être est ensuite réalisée dans la cavité 236, à l'aide d'un procédé Damascène, lors duquel on effectue tout d'abord un dépôt d'un isolant 242, autour des portions des fils 220a dévoilés par la cavité 236. Ce dépôt peut être conforme, d'épaisseur par exemple de l'ordre de 1 à 10 nanomètres, et à base par exemple de SiO₂, ou par exemple d'un matériau diélectrique de type communément appelé « high-k » tel que le HfO₂.

Ensuite, la cavité 236 est remplie à base d'un matériau 244 de grille, qui peut être semi-conducteur tel que par exemple du polysilicium ou métallique, tel que par exemple du molybdène (figure 3I) .

Dans le cas où le remplissage de la cavité dépasse de l'embouchure de cette dernière et recouvre la couche isolante 235, une étape de CMP (CMP pour « chemical mechanical polishing » ou polissage mécanochimique) peut être prévue pour ne conserver le matériau 244 de grille 240, dans la cavité 236 que jusqu'au niveau de l'embouchure de cette dernière.

Comme cela été évoqué plus haut, au moins une région de drain ainsi qu'au moins une région de source sont destinées à être formées, respectivement, dans la première partie 210 et dans la deuxième partie 230, de l'empilement 205.

Selon une possibilité de réalisation de ces régions de drain et de source, on peut, après formation de la grille 240, retirer la couche isolante 235 au dessus des parties 210 et 230 de l'empilement 205, afin de procéder à une implantation ionique par exemple à base d'As ou de P ou de B ou de BF2, puis à une siliciuration des parties 210 et 230.

Selon une variante du procédé, avant l'étape de formation de la grille 240 dans la cavité 235, on peut réaliser des espaceurs qui permettront de séparer électriquement la grille, d'une part, de la partie 210 de l'empilement 205 destinée à former une région de source de transistor, et d'autre part, de la partie 230 de l'empilement 205 destinée à former une région de drain.

## Revendications

1. Procédé de réalisation d'un dispositif microélectronique doté d'un ou plusieurs fils aptes à former un canal de transistor ou un canal de transistor à plusieurs branches ou plusieurs canaux de transistors, le procédé comprenant les étapes de :
a) formation dans une ou plusieurs couches minces reposant sur un support, d'au moins un premier bloc (210) et d'au moins un second bloc (230) dans lesquels respectivement au moins une région de drain et au moins une région de source sont destinées à être formés, et d'au moins une structure (205a) reliant le premier bloc (210) et le second bloc (230),
b) formation sur au moins un flanc de la structure (205a) d'un ou plusieurs fils (220a), reliant une première zone du premier bloc (210) et une autre zone du second bloc (230), aptes à former un canal ou un canal de transistor à plusieurs branches ou plusieurs canaux de transistors.

2. Procédé de réalisation d'un dispositif microélectronique selon la revendication 1, dans lequel le premier bloc et second bloc (210, 230) et la structure sont formés d'un empilement (205) de couches minces, le procédé comprenant en outre, avant l'étape a) : la réalisation sur le support de cet empilement (205) de couches minces.

3. Procédé de réalisation d'un dispositif microélectronique selon la revendication 1 ou 2, comprenant en outre, après l'étape b) : une étape de suppression, entre le premier bloc (210) et le deuxième bloc (220), sélective vis-à-vis des fils (220a), d'au moins une partie de la structure (205a).

4. Procédé de réalisation d'un dispositif microélectronique selon l'une des revendications 1 à 3, dans lequel le premier bloc et second bloc (210, 230) et la structure sont formés dans un empilement (205) de couches minces, l'étape a) comportant les étapes de :
- formation d'au moins un masquage sur ledit empilement,
- gravure anisotrope de l'empilement (205) à travers le masquage (208).

5. Procédé de réalisation d'un dispositif microélectronique selon l'une des revendications 1 à 4, dans lequel le premier bloc et second bloc (210, 230) et la structure sont formés dans un empilement (205) de couches minces, les fils (220a) à l'étape b) étant réalisés par croissance ou par croissance sélective d'au moins un matériau semi-conducteur (214) autour d'une ou plusieurs couches données (204₁, ..., 204ₙ₋₁) de l'empilement (205).

6. Procédé de réalisation d'un dispositif microélectronique selon l'une des revendications 1 à 5, dans lequel le premier bloc et second bloc (210, 230) et la structure (205a) sont formés dans un empilement (205) de couches minces, l'empilement (205) étant formé d'au moins deux couches successives (203,204₁) à base de matériaux (206,207) différents ou d'au moins une paire de couches successives (203,204₁) à base de matériaux (206,207) différents.

7. Procédé de réalisation d'un dispositif microélectronique selon l'une des revendications 1 à 6, dans lequel le premier bloc et second bloc (210, 230) et la structure (205a) sont formés dans un empilement (205) de couches minces, l'empilement (205) étant formé d'une alternance de couches à base d'un premier matériau (206) semi-conducteur, et d'autres couches à base d'un deuxième matériau (207), différent du premier matériau (206).

8. Procédé de réalisation d'un dispositif microélectronique selon l'une des revendications 2 à 7, dans lequel le premier bloc, le second bloc (210, 230) et la structure (205a) sont formés dans un empilement (205) de couches minces et dans lequel l'empilement (205) est formé d'une ou plusieurs couches à base d'un premier matériau (206), et d'une ou plusieurs autres couches à base d'un deuxième matériau (207), le procédé comprenant en outre après l'étape a) et avant l'étape b), les étapes de :
- gravure partielle et sélective du deuxième matériau (207) vis-à-vis des couches à base du premier matériau (206),
- formation d'une épaisseur isolante (211) autour des couches (203,204₂..., 204ₙ₋₁) à base du premier matériau (206).

9. Procédé de réalisation d'un dispositif microélectronique selon la revendication 8, l'étape b) étant réalisée, par croissance ou par croissance par épitaxie, sur le deuxième matériau (207), d'un troisième matériau (211), le troisième matériau (211) étant différent du premier matériau (206) et/ou du deuxième matériau (207).

10. Procédé de réalisation d'un dispositif microélectronique selon l'une des revendications 3 à 9, comprenant en outre, après l'étape de suppression d'au moins une partie de la structure, sélective vis-à-vis des fils (220a), les étapes de :
- dépôt d'une couche isolante (235) sur la structure (205a),
- formation d'au moins une ouverture (236) dans la couche isolante (235) entre le premier bloc et le deuxième bloc, dévoilant la structure (205a) et les fils (220a) ou dévoilant une partie de la structure (205a) et des fils (220a),
- gravure de la structure (205a) à travers l'ouverture (236), sélective vis-à-vis des fils (220a).

11. Procédé de réalisation d'un dispositif microélectronique selon la revendication 10, comprenant en outre, après la gravure de la structure (205a) à travers l'ouverture (236), la formation d'une grille (250) de transistor dans l'ouverture (236).

12. Procédé de réalisation d'un dispositif microélectronique selon l'une des revendications 1 à 11, la première zone du premier bloc (210) et ladite autre zone du second bloc (230) étant à base d'un ou de matériaux différent(s) du matériau (214) à base duquel sont formés les fils (220a).

13. Procédé de réalisation d'un dispositif microélectronique selon l'une des revendications 1 à 12, les fils (220a) formés à l'étape b) étant distincts ou disjoints.

14. Procédé de réalisation d'un dispositif microélectronique selon l'une des revendications 1 à 13, un ou plusieurs fils (220a) formés à l'étape b), ou tous les fils (220a) formés à l'étape b) étant distincts du support.

15. Procédé de réalisation d'un dispositif microélectronique selon l'une des revendications 1 à 14, les fils (220a) formés à l'étape b) ayant une forme cylindrique.

16. Procédé de réalisation d'un dispositif microélectronique selon l'une des revendications 1 à 15, les fils (220a) formés à l'étape b) étant dotés d'un profil arrondi ou présentant une courbure.

17. Procédé de réalisation d'un dispositif microélectronique selon l'une des revendications 1 à 16, les fils (220a) formés à l'étape b) comportant au moins une encoche ou/et au moins un méplat.

18. Procédé de réalisation d'un dispositif microélectronique selon l'une des revendication 1 à 17, dans lequel le support est formé d'au moins une couche semi-conductrice (201) et d'au moins une couche isolante (202) reposant sur la couche semi-conductrice (201), l'empilement (205) de couches minces formé à l'étape a) reposant sur la couche isolante (202).

19. Dispositif microélectronique comprenant :
- un support,
- au moins un premier bloc (110) et au moins un second bloc (130) reposant sur le support, dans lesquels respectivement, au moins une région de drain et au moins une région de source sont aptes à être formées,
- plusieurs fils cylindriques (120a, 120b, 120c, 120d), reliant une première zone du premier bloc (110) et une autre zone du second bloc (130), et aptes à former un canal de transistor ou un canal de transistor à plusieurs branches ou plusieurs canaux de transistors, les fils (120a, 120b, 120c, 120d) sont rattachés à une portion de la première zone du premier bloc (110) et à une autre portion de ladite autre zone du second bloc (130), au moins deux fils (120a, 120b) étant alignés dans une direction réalisant un angle non nul avec un plan principal du support, et au moins un fil de la pluralité de fils étant à base d'un matériau différent de la portion respective de la première zone ou/et de l'autre portion respective de ladite autre zone du second bloc auquel il est rattaché.

20. Dispositif microélectronique selon la revendication 19, les fils étant dotés d'un profil arrondi ou d'un profil présentant une courbure.

21. Dispositif microélectronique selon l'une des revendications 19 ou 20, au moins un fil parmi lesdits fils (120a, 120b, 120c, 120d) n'étant pas en contact avec le support.

22. Dispositif microélectronique selon l'une des revendications 19 à 21, au moins deux fils (120a, 120c) étant alignés dans une direction parallèle au plan principal du support.

23. Dispositif microélectronique selon l'une des revendications 19 à 22, le premier bloc (110) et le second bloc (130) comprenant au moins une couche à base d'un premier matériau semi-conducteur, et au moins une couche à base d'un deuxième matériau semi-conducteur, différent du premier matériau semi-conducteur.

24. Dispositif microélectronique selon l'une des revendications 19 à 23, le premier bloc et le second bloc comprenant une alternance de couches à base d'un premier matériau semi-conducteur et de couches à base d'un deuxième matériau semi-conducteur, différent du premier matériau semi-conducteur.

25. Dispositif microélectronique selon l'une des revendications 23 ou 24, les fils (110a, 110b, 110c, 110d) étant à base d'un troisième matériau semi-conducteur, différent du premier matériau semi-conducteur et du deuxième matériau semi-conducteur.

26. Dispositif microélectronique selon l'une des revendications 19 à 25, comprenant en outre :
au moins une grille (150) enrobant au moins partiellement lesdits fils (120a, 120b).

27. Dispositif microélectronique selon la revendication 26, le support et au moins un desdits fils (120a, 120b, 120c, 120d) étant séparés par une portion de grille (150).

28. Dispositif microélectronique selon l'une des revendications 19 à 27, dans lequel les fils (120a, 120b, 120c, 120d) ont une profil arrondi ou un profil présentant une courbure, et comportent au moins un méplat, ou/et au moins un renfoncement.

29. Dispositif microélectronique selon l'une des revendications 19 à 28, dans lequel, le support est formé d'une couche semi-conductrice (101) recouverte par une couche isolante (102), le premier bloc (110) et le second bloc (130) reposant sur la couche isolante (102).

30. Dispositif microélectronique selon l'une des revendications 19 à 29, les fils étant distincts ou disjoints.

## Claims

1. Method for fabricating a microelectronic device provided with one or more wires able to form a transistor channel or transistor channel having several branches or several transistor channels, the method comprising the steps of:
a) the forming, in one or more thin layers resting on a support, of at least one first block (210) and at least one second block (230) in which at least one drain region and at least one source region are respectively intended to be formed, and of at least one structure (205a) connecting the first block (210) to the second block (230),
b) forming, on at least one side of the structure (205a), one or more wires (220a) linking a first region of the first block (210) and another region of the second block (230), able to form a transistor channel, or transistor channel with several branches or several transistor channels.

2. Method for fabricating a microelectronic device according to claim 1, wherein the first block and second block (210, 230) and the structure are formed of a stack (205) of thin layers, the method also comprising before step a): the forming of thin layers on the support of this stack (205).

3. Method for fabricating a microelectronic device according to claim 1 or 2, also comprising after step b): a removal step, between the first block (210) and the second block (220), that is
selective with respect to the wires (220a), to remove at least part of the structure (205a).

4. Method for fabricating a microelectronic device according to any of claims 1 to 3, wherein the first block and second block (210, 230) and the structure are formed in a stack (205) of thin layers, step a) comprising the steps of:
- forming at least one mask on said stack,
- anisotropic etching of the stack (205) through the mask (208).

5. Method for fabricating a microelectronic device according to any of claims 1 to 4, wherein the first block and second block (210, 230) and the structure are formed in a stack (205) of thin layers, the wires (220a) in step b) being formed by growth or selective growth of at least one semiconductor material (214) around one or more given layers (204₁, ..., 204ₙ₋₁) of the stack (205).

6. Method for fabricating a microelectronic device according to any of claims 1 to 5, wherein the first block and second block (210, 230) and the structure (205a) are formed in a stack (205) of thin layers, the stack (205) being formed of at least two successive layers (203,204₁) in different materials (206,207) or of at least one pair of successive layers (203,204₁) in different materials (206,207).

7. Method for fabricating a microelectronic device according to any of claims 1 to 6, wherein the first block and second block (210, 230) and the structure (205a) are formed in a stack (205) of thin layers, the stack (205) being formed of layers in a first semiconductor material (206) alternating with other layers in a second material (207), different from the first material(206).

8. Method for fabricating a microelectronic device according to any of claims 2 to 7, wherein the first block and second block (210, 230) and the structure (205a) are formed in a stack (205) of thin layers, and wherein the stack (205) is formed of one or more layers in a first material (206) and of one or more layers in a second material (207), the method also comprising, after step a) and before step b), the steps of:
- partial, selective etching of the second material (207)with respect to the layers in the first material (206),
- forming an insulating thickness (211) around the layers (203,204₂..., 204ₙ₋₁) in the first material(206).

9. Method for fabricating a microelectronic device according to claim 8, step b) being performed, by growth or epitaxial growth, of a third material (211) on the second material (207), the third material (211)being different from the first material (206) and/or the second material (207).

10. Method for fabricating a microelectronic device according to any of claims 3 to 9, also comprising after the removal step of at least part of the structure that is selective in regard to the wires (220a), the steps of:
- depositing an insulating layer (235) on the structure (205a),
- forming at least one opening (236) in the insulating layer (235) between the first block and the second block, exposing the structure (205a) and the wires (220a) or exposing part of the structure (205a) and some wires (220a),
- etching the structure (205a) through the opening (236), etching being selective in regard to the wires (220a).

11. Method for fabricating a microelectronic device according to claim 10, also comprising, after etching the structure (205a) through the opening (236), the formation of a transistor gate (250) in the opening (236).

12. Method for fabricating a microelectronic device according to any of claims 1 to 11, the first region of the first block (210) and said other region of the second block (230) being in a material or materials different from the material (214) in which the wires (220a) are formed.

13. Method for fabricating a microelectronic device according to any of claims 1 to 12, the wires (220a) formed in step b) being separate or disjoined.

14. Method for fabricating a microelectronic device according to any of claims 1 to 13, one or more wires (220a) formed in step b), or all the wires (220a) formed in step b) being separate from the support.

15. Method for fabricating a microelectronic device according to any of claims 1 to 14, the wires (220a) formed at step b) having a cylindrical shape.

16. Method for fabricating a microelectronic device according to any of claims 1 to 15, the wires (220a) formed at step b) being provided with a rounded or curved profile.

17. Method for fabricating a microelectronic device according to any of claims 1 to 16, the wires (220a) formed at step b) comprising at least one notch or/and at least one flat surface.

18. Method for fabricating a microelectronic device according to any of claims 1 to 17, wherein the support is formed of at least one semiconductor layer (201) and of at least one insulating layer (202) resting on the semi-conductor layer (201), the stack (205) of thin layers formed at step a) resting on the insulating layer(202).

19. Microelectronic device comprising:
- a support,
- at least one first block (110) and at least one second block (130) resting on the support, in which respectively at least one drain region and at least one source region are able to be formed,
- several cylindrical wires (110a, 110b, 110c, 110d), connecting a first region of the first block (110) with another region of the second block (130), and able to form a transistor channel or a transistor channel with several branches or several transistor channels, the wires (110a, 110b, 110c, 110d) being attached to a portion of the first region of the first block (110) and to another portion of said other region of the second block (130), at least two wires (110a, 110b) being aligned in a direction forming a nonzero angle with a main plane of the support, at least one given wire among the wires being in a material different from the respective portion of the first region or/and of the other respective portion of said other region of the second block to which this given wire is attached.

20. Microelectronic device according to claim 19, the wires being provided with a rounded or curved profile.

21. Microelectronic device according to any of claims 19 or 20, at least one wire amongst said wires (110a, 110b, 110c, 110d) not being in contact with the support.

22. Microelectronic device according to any of claims 19 to 21, at least two wires (110a, 110c) being aligned in a direction parallel to the main plane of the support.

23. Microelectronic device according to any of claims 19 to 22, the first block (110) and the second block (130) comprising at least one layer in a first semiconductor material, and at least one layer in a second semiconductor material, different from the first semiconductor material.

24. Microelectronic device according to any of claims 19 to 23, the first block and the second block comprising alternating layers in a first semiconductor material and layers in a second semiconductor material different from the first semiconductor material.

25. Microelectronic device according to either of claims 23 or 24, the wires (120a, 120b, 120c, 120d) being in a third semiconductor material different from the first semiconductor material and from the second semiconductor material.

26. Microelectronic device according to any of claims 19 to 25, also comprising: at least one gate (150) coating said wires (120a, 120b) at least in part.

27. Microelectronic device according to claim 26, the support and at least one of said wires (120a, 120b, 120c, 120d) being separated by a gate portion (150).

28. Microelectronic device according to any of claims 19 to 27, wherein the wires (120a, 120b, 120c, 120d) have a rounded or curved profile, and comprise at least one flat surface or/and at least one recess.

29. Microelectronic device according to any of claims 19 to 28, wherein the support is formed of a semiconductor layer (101) covered by an insulating layer (102), the first block (110) and the second block (130) resting on the insulating layer(102).

30. Microelectronic device according to any of claims 19 to 29, the wires being separate or disjoined.

## Patentansprüche

1. Verfahren zur Realisierung einer mikroelektronischen Vorrichtung, die mit einem oder mehreren Drähten versehen ist, welche geeignet sind, einen Transistorkanal oder einen Transistorkanal mit mehreren Armen oder mehrere Transistorkanäle zu bilden, wobei das Verfahren die folgenden Schritte beinhaltet:
a) Ausbilden, in einer oder mehreren dünnen Schichten, die auf einem Träger aufliegen, mindestens eines ersten Blockes (210) und mindestens eines zweiten Blocks (230), in denen jeweils mindestens ein Drain-Gebiet und mindestens ein Source-Gebiet ausgebildet werden sollen, und mindestens einer Struktur (205a), die den ersten Block (210) und den zweiten Block (230) verbindet,
b) Ausbilden, auf mindestens einer Flanke der Struktur (205a), eines oder mehrerer Drähte (220a), die eine erste Zone des ersten Blocks (210) und eine weitere Zone des zweiten Blocks (230) verbinden, und die geeignet sind, einen Kanal oder einen Transistorkanal mit mehreren Armen oder mehrere Transistorkanäle zu bilden.

2. Verfahren zur Realisierung einer mikroelektronischen Vorrichtung nach Anspruch 1, bei dem der erste Block und der zweite Block (210, 230) und die Struktur aus einer Übereinanderschichtung (205) von dünnen Schichten gebildet werden, wobei das Verfahren weiter beinhaltet, vor dem Schritt a): das Realisieren auf dem Träger von dieser Übereinanderschichtung (205) von dünnen Schichten.

3. Verfahren zur Realisierung einer mikroelektronischen Vorrichtung nach Anspruch 1 oder 2, das weiter beinhaltet, nach dem Schritt b): einen Schritt eines Beseitigens, zwischen dem ersten Block (210) und dem zweiten Block (220), selektiv gegenüber den Drähten (220a), mindestens eines Teils der Struktur (205a).

4. Verfahren zur Realisierung einer mikroelektronischen Vorrichtung nach einem der Ansprüche 1 bis 3, bei dem der erste Block und der zweite Block (210, 230) und die Struktur in einer Übereinanderschichtung (205) von dünnen Schichten ausgebildet werden, wobei Schritt a) die folgenden Schritte beinhaltet:
- Ausbilden mindestens einer Maskierung auf der Übereinanderschichtung,
- anisotropes Ätzen der Übereinanderschichtung (205) über die Maskierung (205).

5. Verfahren zur Realisierung einer mikrociektronischen Vorrichtung nach einem der Ansprüche 1 bis 4, bei dem der erste Block und der zweite Block (210, 230) und die Struktur in einer Übereinanderschichtung (205) von dünnen Schichten ausgebildet werden, wobei die Drähte (220a) bei Schritt b) durch Aufwachsen oder durch selektives Aufwachsen mindestens eines Halbleitermaterials (214) herum um eine oder mehrere gegebene Schichten (204₁ ..., 204ₙ₋₁) der Übereinanderschichtung (205) realisiert werden.

6. Verfahren zur Realisierung einer mikroelektronischen Vorrichtung nach einem der Ansprüche 1 bis 5, bei dem der erste Block und der zweite Block (210, 230) und die Struktur (205a) in einer Übereinanderschichtung (205) von dünnen Schichten ausgebildet werden, wobei die Übereinanderschichtung (205) aus mindestens zwei aufeinanderfolgenden Schichten (203, 204₁) auf Basis unterschiedlicher Materialien (206, 207) oder mindestens einem Paar von aufeinanderfolgenden Schichten (203, 204ᵢ) auf Basis unterschiedlicher Materialien (206, 207) ausgebildet wird.

7. Verfahren zur Realisierung einer mikroelektronischen Vorrichtung nach einem der Ansprüche 1 bis 6, bei dem der erste Block und der zweite Block (210, 230) und die Struktur (205a) in einer Übereinanderschichtung (205) von dünnen Schichten ausgebildet werden, wobei die Übereinanderschichtung (205) aus einer abwechselnden Anordnung von Schichten auf Basis eines ersten Halbleitermaterials (206) und weiterer
Schichten auf Basis eines zweiten Materials (207), das vom ersten Material (206) verschieden ist, gebildet werden.

8. Verfahren zur Realisierung einer mikroelektronischen Vorrichtung nach einem der Ansprüche 2 bis 7, bei dem der erste Block, der zweite Block (210, 230) und die Struktur (205a) in einer Übereinanderschichtung (205) von dünnen Schichten ausgebildet werden, und bei dem die Übereinanderschichtung (205) aus einer oder mehreren Schichten auf Basis eines ersten Materials (206) und aus einer oder mehreren weiteren Schichten auf Basis eines zweiten Materials (207) gebildet wird, wobei das Verfahren, nach Schritt a) und vor Schritt b), weiter folgende Schritte beinhaltet:
- partielles und selektives Ätzen des zweiten Materials (207) gegenüber den Basisschichten des ersten Materials (206),
- Ausbilden einer isolierenden Dicke (211) herum um die Schichten (203, 204₂, ..., 204ₙ₋₁) auf Basis des ersten Materials (206).

9. Verfahren zur Realisierung einer mikroelektronischen Vorrichtung nach Anspruch 8, wobei Schritt b) durch Aufwachsen oder durch epitaktischen Aufwachsen auf dem zweiten Material (207) eines dritten Materials (211) realisiert wird, wobei das dritte Material (211) vom ersten Material (206) und/oder dem zweiten Material (207) verschieden ist.

10. Verfahren zur Realisierung einer mikroelektronischen Vorrichtung nach einem der Ansprüche 3 bis 9, das weiter, nach dem Schritt des Beseitigens zumindest eines Teils der Struktur, selektiv gegenüber den Drähten (220a), folgende Schritte beinhaltet:
- Ablagern einer isolierenden Schicht (235) auf der Struktur (205a),
- Ausbilden mindestens einer Öffnung (236) in der isolierenden Schicht (235) zwischen dem ersten Block und dem zweiten Block, wobei die Struktur (205a) und die Drähte (220a) freigelegt werden oder ein Teil der Struktur (205a) und der Drähte (220a) freigelegt wird,
- Ätzen der Struktur (205a) über die Öffnung (236), selektiv gegenüber den Drähten (220a).

11. Verfahren zur Realisierung einer mikroelektronischen Vorrichtung nach Anspruch 10, das weiter, nach dem Ätzen der Struktur (205a) über die Öffnung (236), das Ausbilden eines Transistor-Gate (250) in der Öffnung (236) beinhaltet.

12. Verfahren zur Realisierung einer mikroelektronischen Vorrichtung nach einem der Ansprüche 1 bis 11, wobei die erste Zone des ersten Blocks (210) und die weitere Zone des zweiten Blocks (230) auf Basis eines oder mehrerer Materialien sind, die von dem Material (214) verschieden sind, auf Basis dessen die Drähte (220a) ausgebildet werden.

13. Verfahren zur Realisierung einer mikroelektronischen Vorrichtung nach einem der Ansprüche 1 bis 12, wobei die bei Schritt b) gebildeten Drähte (220a) verschieden oder getrennt sind.

14. Verfahren zur Realisierung einer mikroelektronischen Vorrichtung nach einem der Ansprüche 1 bis 13, wobei einer oder mehrere der bei Schritt b) gebildeten Drähte (220a), oder alle bei Schritt b) gebildeten Drähte (220a) vom Träger verschieden sind.

15. Verfahren zur Realisierung einer mikroelektronischen Vorrichtung nach einem der Ansprüche 1 bis 14, wobei die bei Schritt b) gebildeten Drähte (220a) zylindrische Form haben.

16. Verfahren zur Realisierung einer mikroelektronischen Vorrichtung nach einem der Ansprüche 1 bis 15, wobei die bei Schritt b) gebildeten Drähte (220a) mit einem gerundeten Profil versehen sind oder eine Krümmung aufweisen.

17. Verfahren zur Realisierung einer mikroelektronischen Vorrichtung nach einem der Ansprüche 1 bis 16, wobei die bei Schritt b) gebildeten Drähte (220a) mindestens eine Einkerbung und/oder mindestens eine Abflachung aufweisen.

18. Verfahren zur Realisierung einer mikroelektronischen Vorrichtung nach einem der Ansprüche 1 bis 17, bei dem der Träger aus mindestens einer halbleitenden Schicht (201) und mindestens einer isolierenden Schicht (202) ausgebildet ist, die auf der halbleitenden Schicht (201) aufliegt, wobei die Übereinanderschichtung (205) von dünnen Schichten, die bei Schritt a) ausgebildet wird, auf der isolierenden Schicht (202) aufliegt.

19. Mikroelektronische Vorrichtung, aufweisend:
- einen Träger,
- mindestens einen ersten Block (110) und mindestens einen zweiten Block (130), der auf dem Träger aufliegt, in denen jeweils mindestens ein Drain-Gebiet und mindestens ein Source-Gebiet ausgebildet werden können,
- mehrere zylindrische Drähte (120a, 120b, 120c, 120d), die eine erste Zone des ersten Blocks (110) und eine weitere Zone des zweiten Blocks (130) verbinden und geeignet sind, einen Transistorkanal oder einen Transistorkanal mit mehreren Armen oder mehrere Transistorkanäle zu bilden, wobei die Drähte (120a, 120b, 120c, 120d) an einem Abschnitt der ersten Zone des ersten Blocks (110) und einem weiteren Abschnitt der weiteren Zone des zweiten Blocks (130) angebracht sind, wobei mindestens zwei Drähte (120a, 120b) in einer Richtung ausgerichtet sind, die einen Winkel von nicht Null mit einer Hauptebene des Trägers bildet, und mindestens ein Draht von der Mehrzahl von Drähten auf Basis eines Materials ist, das von dem jeweiligen Abschnitt der ersten Zone und/oder dem jeweiligen weiteren Abschnitt der weiteren Zone des zweiten Blocks verschieden ist, an dem er angebracht ist.

20. Mikroelektronische Vorrichtung nach Anspruch 19, wobei die Drähte mit einem gerundeten Profil oder einem eine Krümmung aufweisenden Profil versehen sind.

21. Mikroelektronische Vorrichtung nach einem der Ansprüche 19 oder 20, wobei mindestens ein Draht von den Drähten (120a, 120b, 120c. 120d) nicht in Kontakt mit dem Träger ist.

22. Mikroelektronische Vorrichtung nach einem der Ansprüche 19 bis 21, wobei mindestens zwei Drähte (120a, 120c) in einer Richtung parallel zur Hauptebene des Trägers ausgerichtet sind.

23. Mikroelektronische Vorrichtung nach einem der Ansprüche 19 bis 22, wobei der erste Block (110) und der zweite Block (130) mindestens eine Schicht auf Basis eines ersten Halbleitermaterials und mindestens eine Schicht auf Basis eines zweiten Halbleitermaterials aufweisen, das vom ersten Halbleitermaterial verschieden ist.

24. Mikroelektronische Vorrichtung nach einem der Ansprüche 19 bis 23, wobei der erste Block und der zweite Block eine abwechselnde Anordnung von Schichten auf Basis eines ersten Halbleitermaterials und von Schichten auf Basis eines zweiten Halbleitermaterials aufweisen, das vom ersten Halbleitermaterial verschieden ist.

25. Mikroelektronische Vorrichtung nach einem der Ansprüche 23 oder 24, wobei die Drähte (120a, 120b, 120c, 120d) auf Basis eines dritten Halbleitermaterials sind, das vom ersten Halbleitermaterial und vom zweiten Halbleitermaterial verschieden ist.

26. Mikroelektronische Vorrichtung nach einem der Ansprüche 19 bis 25, weiter aufweisend:
mindestens ein Gate (150), das die Drähte (120a, 120b) zumindest teilweise umhüllt.

27. Mikroelektronische Vorrichtung nach Anspruch 26, wobei der Träger und mindestens einer der Drähte (120a, 120b, 120c, 120d) durch einen Gate-Abschnitt (150) getrennt sind.

28. Mikroelektronische Vorrichtung nach einem der Ansprüche 19 bis 27, bei der die Drähte (120a, 120b, 120c, 120d) ein gerundetes Profil oder ein eine Krümmung aufweisendes Profil aufweisen, und mindestens eine Abflachung, und/oder mindestens eine Verstärkung aufweisen.

29. Mikroelektronische Vorrichtung nach einem der Ansprüche 19 bis 28, bei welcher der Träger aus einer halbleitenden Schicht (101) gebildet ist, die von einer isolierenden Schicht (102) bedeckt ist, wobei der erste Block (110) und der zweite Block (130) auf der isolierenden Schicht (102) aufliegen.

30. Mikroelektronische Vorrichtung nach einem der Ansprüche 19 bis 29, wobei die Drähte verschieden oder getrennt sind.
